(19) Europäisches Patentamt
European Patent Office
Office européen des brevets

(11) EP 3 733 792 A1

(12) EUROPEAN PATENT APPLICATION

(43) Date of publication:
**04.11.2020 Bulletin 2020/45**

(21) Application number: **19171772.7**

(22) Date of filing: **30.04.2019**

(51) Int Cl.:
***C09D 11/52*** *(2014.01)* ***C09D 11/38*** *(2014.01)*
***C09D 11/037*** *(2014.01)* ***H05K 3/12*** *(2006.01)*

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **AGFA-GEVAERT NV**
**2640 Mortsel (BE)**

(72) Inventors:
- **MUYS, Bavo**
  **2640 Mortsel (BE)**
- **WILLAERT, Peter**
  **2640 Mortsel (BE)**
- **VAN DEN BOSSCHE, Karl**
  **2640 Mortsel (BE)**
- **CORTES SALAZAR, Fernando**
  **2640 Mortsel (BE)**

(74) Representative: **Viaene, Kris**
**AGFA NV**
**Intellectual Property Department**
**Septestraat 27**
**2640 Mortsel (BE)**

# (54) A METHOD OF MANUFACTURING A CONDUCTIVE PATTERN

(57) A method of preparing a conductive silver pattern on a substrate comprising the steps of:
- applying a silver ink on the substrate to form a silver pattern, and
- sintering the applied silver pattern in one step at a temperature of at least 50°C and a relative humidity (RH) of at least 50 %.

EP 3 733 792 A1

## Description

### Field of the Invention

The invention relates to a method of preparing a conductive pattern on various substrates.

### Background of the Invention

The interest in metallic printing or coating fluids comprising metallic nanoparticles has increased during the last decades due to their unique properties when compared to the bulk properties of a given metal. For example, the melting point of metallic nanoparticles decreases with decreasing particle size making them of interest for printed electronics, electrochemical, optical, magnetic and biological applications.

The production of stable and concentrated metallic printing or coating fluids that can be printed, for example by inkjet printing, or coated at high speed is of great interest as it enables the preparation of electronic devices at low costs.

Metallic printing or coating fluids are typically metallic nanoparticle dispersions comprising metallic nanoparticles and a dispersion medium. Such metallic nanoparticle dispersions can be directly used as a printing or coating fluid. However, additional ingredients are often added to the metallic nanoparticle dispersion to optimize the properties of the resulting metallic printing or coating fluids.

EP-A 2671927 (Agfa Gevaert) discloses a metallic nanoparticle dispersion, for example a silver inkjet ink, comprising a specific dispersion medium, for example 2-pyrrolidone, resulting in a more stable dispersion without using a polymeric dispersant.

Typically, after applying the metallic printing or coating fluids on a substrate, a sintering step, also referred to as curing step, at elevated temperatures is carried out to induce/enhance the conductivity of the applied patterns or layers.

Organic components of the metallic printing or coating fluids, for example polymeric dispersants, may reduce the sintering efficiency and thus the conductivity of the applied patterns or layers. For this reason, higher sintering temperatures and longer sintering times are often required to decompose such organic components.

A high temperature sintering is not possible for substrates that do not withstand high temperatures. For that reason it is often difficult to prepare highly conductive patterns on such substrates.

EP-A 3037161 (Agfa Gevaert) discloses a metallic nanoparticle dispersion comprising silver nanoparticles, a liquid carrier and specific dispersion stabilizing compounds.

WO2017/139641 (TE Connectivity Corp) disclose a method of preparing conductive silver patterns on a substrate wherein after drying/annealing printed silver ink a humidity treatment is carried out. The humidity treatment enables the drying/annealing step to be carried at lower temperatures. However, the "two-step" sintering process introduces extra complexity in the method.

There remains a need for a simplified method of preparing highly conductive silver patterns on substrates that do not withstand high sintering temperatures.

### Summary of the invention

It is an object of the present invention to provide a reliable method of preparing a conductive silver pattern having a high conductivity, sufficient adhesion and a good resolution on various substrates.

This object is realized by the method as defined in claim 1.

Further advantages and embodiments of the present invention will become apparent from the following description and the dependent claims.

### Detailed description of the invention

Definitions

The terms polymeric support and foil, as used herein, mean a self-supporting polymer-based sheet, which may be associated with one or more adhesion layers, e.g. subbing layers. Supports and foils are usually manufactured through extrusion.

The term layer as used herein, is considered not to be self-supporting and is manufactured by coating or spraying it on a (polymeric) support or foil.

PET is an abbreviation for polyethylene terephthalate.

The term alkyl means all variants possible for each number of carbon atoms in the alkyl group i.e. methyl, ethyl, for three carbon atoms: n-propyl and isopropyl; for four carbon atoms: n-butyl, isobutyl and tertiary-butyl; for five carbon atoms: n-pentyl, 1,1-dimethylpropyl, 2,2-dimethylpropyl and 2-methyl-butyl etc.

Unless otherwise specified a substituted or unsubstituted alkyl group is preferably a $C_1$ to $C_6$-alkyl group.
Unless otherwise specified a substituted or unsubstituted alkenyl group is preferably a $C_2$ to $C_6$-alkenyl group.
Unless otherwise specified a substituted or unsubstituted alkynyl group is preferably a $C_2$ to $C_6$-alkynyl group.
Unless otherwise specified a substituted or unsubstituted alkaryl group is preferably a phenyl group or a naphthyl group including one, two, three or more $C_1$ to $C_6$-alkyl groups.
Unless otherwise specified a substituted or unsubstituted aralkyl group is preferably a $C_1$ to $C_6$-alkyl group including an aryl group, preferably a phenyl group or naphthyl group.
Unless otherwise specified a substituted or unsubstituted aryl group is preferably a substituted or unsubstituted phenyl group or naphthyl group.
A cyclic group includes at least one ring structure and may be a monocyclic- or polycyclic group, meaning one or more rings fused together.
A heterocyclic group is a cyclic group that has atoms of at least two different elements as members of its ring(s).The counterparts of heterocyclic groups are homocyclic groups, the ring structures of which are made of carbon only. Unless otherwise specified a substituted or unsubstituted heterocyclic group is preferably a five- or six-membered ring substituted by one, two, three or four heteroatoms, preferably selected from oxygen atoms, nitrogen atoms, sulphur atoms, selenium atoms or combinations thereof.
An alicyclic group is a non-aromatic homocyclic group wherein the ring atoms consist of carbon atoms.
The term heteroaryl group means a monocyclic- or polycyclic aromatic ring comprising carbon atoms and one or more heteroatoms in the ring structure, preferably, 1 to 4 heteroatoms, independently selected from nitrogen, oxygen, selenium and sulphur. Preferred examples of heteroaryl groups include, but are not limited to, pyridinyl, pyridazinyl, pyrimidyl, pyrazyl, triazinyl, pyrrolyl, pyrazolyl, imidazolyl, (1,2,3,)- and (1,2,4)-triazolyl, pyrazinyl, pyrimidinyl, tetrazolyl, furyl, thienyl, isoxazolyl, thiazolyl, isoxazolyl, and oxazolyl. A heteroaryl group can be unsubstituted or substituted with one, two or more suitable substituents. Preferably, a heteroaryl group is a monocyclic ring, wherein the ring comprises 1 to 5 carbon atoms and 1 to 4 heteroatoms.
The term substituted, in e.g. substituted alkyl group means that the alkyl group may be substituted by other atoms than the atoms normally present in such a group, i.e. carbon and hydrogen. For example, a substituted alkyl group may include a halogen atom or a thiol group. An unsubstituted alkyl group contains only carbon and hydrogen atoms.
Unless otherwise specified a substituted alkyl group, a substituted alkenyl group, a substituted alkynyl group, a substituted aralkyl group, a substituted alkaryl group, a substituted aryl, a substituted heteroaryl and a substituted heterocyclic group are preferably substituted by one or more substituents selected from the group consisting of methyl, ethyl, n-propyl, isopropyl,
n-butyl, 1-isobutyl, 2-isobutyl and tertiary-butyl, ester, amide, ether, thioether, ketone, aldehyde, sulfoxide, sulfone, sulfonate ester, sulphonamide, -Cl, -Br, -I, -OH, -SH, -CN and $-NO_2$.

## Method of preparing a conductive silver pattern

The method of preparing a conductive silver pattern on a substrate according to the present invention comprises the steps of:

- applying a silver ink on the substrate to form a silver pattern, and
- sintering the applied silver pattern in one step at temperature of at least 50°C and a relative humidity (RH) of at least 50 %.

The temperature in the one-step sintering method is preferably at least 60°C, more preferably at least 70°C, most preferably at least 80°C.
The one-step sintering method may also be referred to as a single step sintering method.
The relative humidity in the one-step sintering method is preferably at least 60%, more preferably at least 70%, most preferably at least 80%.
The "one-step" sintering step according to the invention enables the formation of high conductive silver patterns at relatively low temperatures. Such low temperatures makes it possible to use substrates that do not withstand high temperatures, such as for example polyvinylchloride (PVC), polycarbonate (PC) or polystyrene (PS) substrates.
An advantage of the "one-step" sintering step compared for example with the "two-step" sintereing proces disclosed in WO2017/139641 is less complexity of the total process and a higher troughput.

## Sintering step

The temperature in the one-step sintering method is preferably at least 60°C, more preferably at least 70°C, most preferably at least 80°C.

The relative humidity in the one-step sintering method is preferably at least 60%, more preferably at least 70%, most preferably at least 80%.

The one-step sintering step according to the invention enables the formation of high conductive silver patterns at relatively low temperatures. Such low temperatures makes it possible to use substrates that do not withstand high temperatures, such as for example PCV substrates.

The one-step sintering step referred to means that the printed silver is not subjected to an additional treatment, such as drying, annealing, heating before it is subjected to the sintering step.

An optional drying step may be carried out after the one-step sintering step.

The amount of time used in the one-step sintering step is between 1 minute and 200 hours, preferably between 5 minutes and 150 hours, more preferably between 10 minutes and 100 hours, most preferaby between 30 minutes and 50 hours.

The one-step sintering step is preferably carried out in an oven with relative humidity control. For instance where a given temperature as well as a precise relative humidity value can be set.

An advantage of the "one-step" sintering step compared for example with the "two-step" sintereing proces disclosed in WO2017/139641 is less complexity of the total process and a higher troughput.

## Silver ink

The silver ink comprises silver particles, preferably silver nanoparticles.

The silver ink may be a flexographic ink, an offset ink, a rotogravure ink, a screen ink, or an inkjet ink.

The silver ink may further comprise a liquid carrier, stabilizing compounds, a binder, a polymeric dispersant and other additives to further optimize its properties.

### Silver particles

The silver ink of the present invention comprises silver particles, preferably silver nanoparticles.

The silver nanoparticles have an average particle size or average particle diameter, measured with Transmission Electron Microscopy, of less than 150 nm, preferably less than 100 nm, more preferably less than 50 nm, most preferably less than 30 nm.

The amount of silver nanoparticles in the ink is preferably at least 5 wt%, more preferably at least 10 wt%, most preferably at least 15 wt %, particularly preferred at least 20 wt%, relative to the total weight of the silver ink.

The silver nanoparticles are preferably prepared by the method disclosed in EP-A 2671927, paragraphs [0044] to [0053] and the examples.

The silver ink may also comprise silver flakes or silver nanowires.

### Dispersion-stabilizing compound (DSC)

The silver inkjet ink preferably comprises silver nanoparticles, a liquid carrier and a dispersion-stabilizing compound (DSC) according to according to Formulae I, II, III or IV,

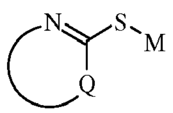
Formula I

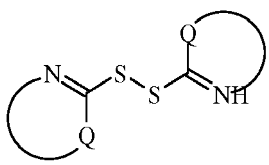
Formula II

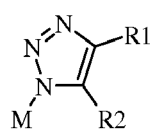
Formula III

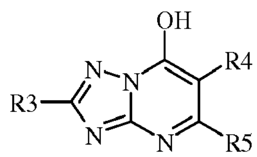
Formula IV

wherein

Q represents the necessary atoms to form a substituted or unsubstituted five or six membered heteroaromatic ring;
M is selected from the group consisting of hydrogen, a monovalent cationic group and an acyl group;
R1 and R2 are independently selected from the group consisting of a hydrogen, a substituted or unsubstituted alkyl group, a substituted or unsubstituted alkenyl group, a substituted or unsubstituted alkynyl group, a substitued or unsubstituted alkaryl group, a substituted or unsubstituted aralkyl group, a substituted or unsubstituted aryl or heteroaryl group, a hydroxyl group, a thioether, an ether, an ester, an amide, an amine, a halogen, a ketone and an aldehyde;
R1 and R2 may represent the necessary atoms to form a five to seven membered ring;

R3 to R5 are independently selected from the group consisting of a hydrogen, a substituted or unsubstituted alkyl group, a substituted or unsubstituted alkenyl group, a substituted or unsubstituted alkynyl group, a substituted or unsubstituted alkaryl group, a substituted or unsubstituted aralkyl group, a substituted or unsubstituted aryl or heteroaryl group, a hydroxyl group, a thiol, a thioether, a sulfone, a sulfoxide, an ether, an ester, an amide, an amine, a halogen, a ketone, an aldehyde, a nitrile and a nitro group;

R4 and R5 may represent the necessary atoms to form a five to seven membered ring.

The dispersion-stabilizing compound is preferably a compound according to Formula I,

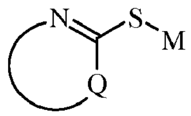

Formula I

wherein

M is selected from the group consisting of hydrogen, a monovalent cationic group and an acyl group; and

Q represents the necessary atoms to form a five membered heteroaromatic ring.

M in Formula I is preferably a hydrogen.

Q is preferably a five membered heteroaromatic ring selected from the group consisting of an imidazole; a benzimidazole; a thiazole; a benzothiazole; an oxazole; a benzoxazole; a 1,2,3-triazole; a 1,2,4-triazole; an oxadiazole; a thiadiazole and a tetrazole.

Q is more preferably a tetrazole.

Some examples of dispersion-stabilizing compounds according to the present invention are shown in Table 1.

Table 1

| DSC | Chemical Formula |
|---|---|
| DCS-01 | 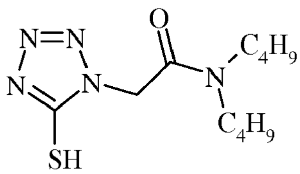 |
| DCS-02 | 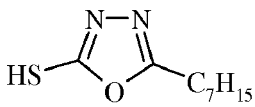 |
| DCS-03 | 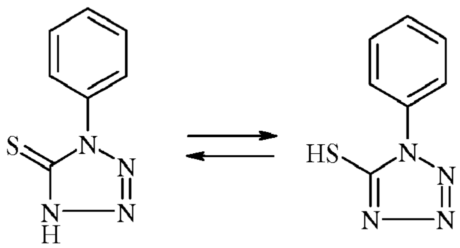 |
| DCS-04 | 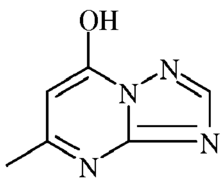 |

(continued)

| DSC | Chemical Formula |
|---|---|
| DCS-05 | 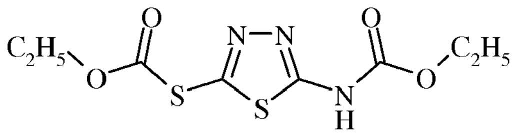 |
| DCS-06 | 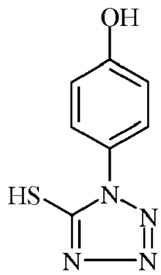 |
| DCS-07 | 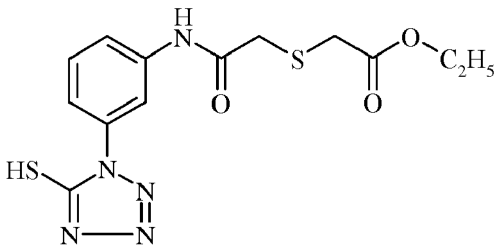 |
| DCS-08 | 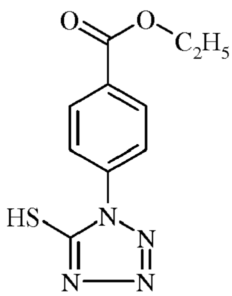 |
| DCS-09 | 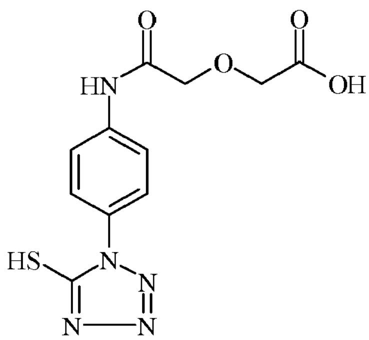 |
| DCS-10 | 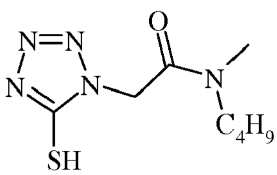 |

(continued)

| DSC | Chemical Formula |
|---|---|
| DCS-11 | 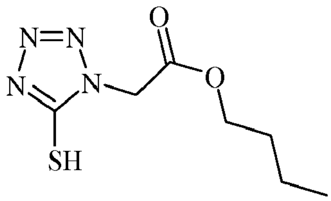 |
| DCS-12 | 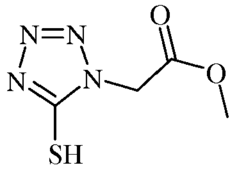 |
| DCS-13 | 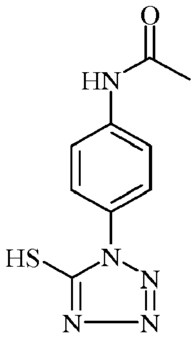 |
| DCS-14 | 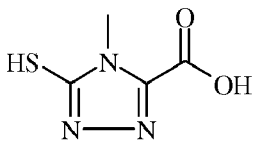 |
| DCS-15 | 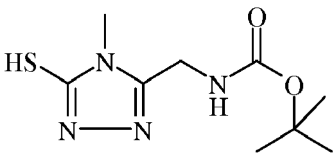 |
| DCS-16 | 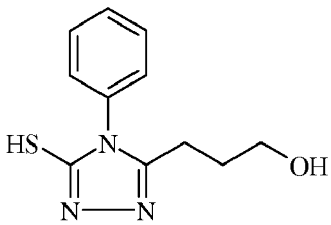 |

The dispersion-stabilizing compound is preferably selected from the group consisting of N,N-dibutyl-(2,5-dihydro-5-thioxo-1H-tetrazol-1-yl-acetamide, 5-heptyl-2-mercapto-1,3,4-oxadiazole, 1-phenyl-5-mercaptotetrazol, 5-methyl-1,2,4-triazolo-(1,5-a) primidine-7-ol, and S-[5-[(ethoxycarbonyl)amino]-1,3,4-thiadiazol-2-yl] O-ethyl thiocarbonate.

The dispersion-stabilizing compounds according to Formulae I to IV are preferably non-polymeric compounds. Non-polymeric compounds as used herein means compounds having a Molecular Weight which is less preferably than 1000, more preferably less than 500, most preferably less than 350.

The amount of the dispersion-stabilizing compound (DSC) expressed as wt% relative to the total weight of silver in the silver ink is at least 1.0, preferably at least 1.25, more preferably at least 2.0. The amount of the dispersion-stabilizing compound expressed as wt% relative to the total weight of silver in the silver ink is preferably lower than 10,

more preferably lower than 7.5, most preferably lower than 5.

When the amount of the dispersion-stabilizing compound relative to the total weight of silver is too low, the stabilizing effect may be too low, while a too high amount of the dispersion-stabilizing compound may adversely affect the conductivity of the coating or patterns obtained with the silver ink.

Polymeric dispersant

The silver ink may contain a polymeric dispersant.

Polymeric dispersants typically contain in one part of the molecule so-called anchor groups, which adsorb onto the silver particles to be dispersed. In another part of the molecule, polymeric dispersants have polymer chains compatible with the dispersion medium, also referred to as liquid vehicle, and all the ingredients present in the final printing or coating fluids.

Polymeric dispersants are typically homo- or copolymers prepared from acrylic acid, methacrylic acid, vinyl pyrrolidinone, vinyl butyral, vinyl acetate or vinyl alcohol monomers.

The polymeric dispersants disclosed in EP-A 2468827, having a 95 wt% decomposition at a temperature below 300°C as measured by Thermal Gravimetric Analysis may also be used.

However, in a preferred embodiment metallic nanoparticle dispersion comprises less than 5 wt% of a polymeric dispersant relative to the total weight of the dispersion, more preferably less than 1 wt%, most preferably less than 0.1 wt%. In a particularly preferred embodiment the dispersion comprises no polymeric dispersant at all.

It has been observed that the presence of a polymeric dispersant may negatively influence the sintering efficiency.

Liquid Carrier

The silver ink preferably comprises a liquid carrier.

The liquid carrier is preferably an organic solvent. The organic solvent may be selected from alcohols, aromatic hydrocarbons, ketones, esters, aliphatic hydrocarbons, higher fatty acids, carbitols, cellosolves, and higher fatty acid esters.

Suitable alcohols include methanol, ethanol, propanol, 1-butanol, 1-pentanol, 2-butanol, t-butanol.

Suitable aromatic hydrocarbons include toluene and xylene.

Suitable ketones include methyl ethyl ketone, methyl isobutyl ketone, 2,4-pentanedione and hexa-fluoroacetone.

Also glycol, glycolethers, N,N-dimethyl- acetamide, N,N-dimethylformamide may be used.

A mixture of organic solvents may be used to optimize the properties of the metallic nanoparticle dispersion.

Preferred organic solvents are high boiling solvents. High boiling organic solvents referred to herein are solvents which have a boiling point that is higher than the boiling point of water (> 100°C).

Preferred high boiling solvents are shown in Table 2.

Table 2

| Chemical formula | Chemical name | Bp (°C) |
|---|---|---|
| 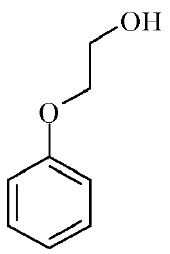 | 2-phenoxy ethanol (ethylene glycol monophenylether) | 247 |
| 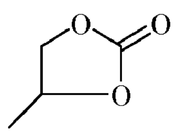 | 4-methyl-1,3-dioxolan-2-one (propylene carbonate) | 242 |
| 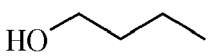 | n-butanol | 117 |

(continued)

| Chemical formula | Chemical name | Bp (°C) |
|---|---|---|
| 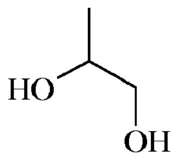 | 1,2-propanediol | 211-217 |
| 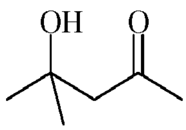 | 4-hydroxy-4-methylpentan-2-one (diaceton alcohol) | 168 |
| 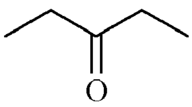 | Pentan-3-one (diethyl ketone) | 102 |
| 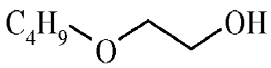 | 2-Butoxyethanol Ethylene glycol monobutyl ether | 171 |
| 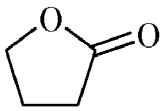 | Dihydrofuran-2(3H)-one (Gamma-butyrolacton) | 204 |
| 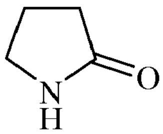 | 2-pyrrolidon | 245 |
| 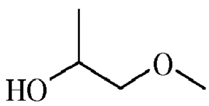 | 1-methoxy-2-propanol (propyleneglycolmonomethylether | 120 |

Particularly preferred high boiling solvents are 2-phenoxy ethanol, propylene carbonate, propylene glycol, n-butanol, 2-pyrrolidone and mixtures thereof.

The silver ink preferably comprises at least 25 wt% of 2-phenoxyethanol, more preferably at least 40 wt%, based on the total weight of the silver ink.

Additives

To optimize the printing properties, and also depending on the application for which it is used, additives such as reducing agents, wetting/levelling agents, dewettting agents, rheology modifiers, adhesion agents, tackifiers, humectants, jetting agents, curing agents, biocides or antioxidants may be added to the silver ink described above.

The silver ink may comprise a surfactant. Preferred surfactants are Byk® 410 and 411, both solutions of a modified urea, and Byk ® 430, a solution of a high molecular urea modified medium polar polyamide.

The amount of the surfactants is preferably between 0.01 and 10 wt%, more preferably between 0.05 and 5 wt%, most preferably between 0.1 and 0.5 wt %, relative to the total amount of the silver ink.

It may be advantageous to add a small amount of a metal of an inorganic acid or a compound capable of generating such an acid to the silver ink as disclosed in EP-A 2821164. Higher conductivities were observed of layers or patterns formed from such silver inks.

Higher conductivities may also be obtained when silver inks containing a compound according to Formula X, as disclosed in EP-A 3016763.

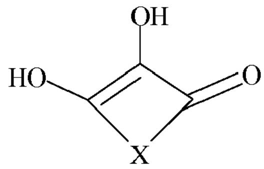

Formula X

wherein
X represents the necessary atoms to form a substituted or unsubstituted ring.

A particularly preferred compound according to Formula X is an ascorbic or erythorbic acid derivative compound.

Substrate

The substrate may a glass, a paper or a polymeric support.

The substrate as used herein is also referred to a support.

Preferred polymeric supports are polycarbonate, polyethylene terephthalate (PET) or polyvinylchloride (PVC) based substrates.

The above mentioned supports may be provided with one or more layers to improve the adhesion, absorption or spreading of the applied conductive inkjet, screen or flexo inks.

Polymeric supports are preferably provided with so-called subbing layers to improve the adhesion of the applied conductive inkjet, screen or flexo inks. Such subbing layers are typically based on vinylidene copolymers, polyesters, or (meth)acrylates.

Useful subbing layers for this purpose are well known in the art and include, for example, polymers of vinylidene chloride such as vinylidene chloride/acrylonitrile/ acrylic acid terpolymers or vinylidene chloride/methyl acrylate/itaconic acid terpolymers.

Other preferred subbing layers include a binder based on a polyester-urethane copolymer. In a more preferred embodiment, the polyester-urethane copolymer is an ionomer type polyester urethane, preferably using polyester segments based on terephthalic acid and ethylene glycol and hexamethylene diisocyanate. A suitable polyester-urethane copolymer is Hydran™ APX101 H from DIC Europe GmbH.

The application of subbing layers is well-known in the art of manufacturing polyester supports for silver halide photographic films. For example, the preparation of such subbing layers is disclosed in US 3649336 and GB 1441591.

An acid generating compound may be incorporated in a primer layer on a support as disclosed in WO2015/000932. A preferred primer comprises a copolymer of vinylidene chloride, an acrylic ester and itaconic acid.

In a preferred embodiment, the subbing layer has a dry thickness of no more than 0.2 μm or preferably no more than 200 $mg/m^2$.

Another preferred support is a support based on transparent conductive oxides. Such a support is typically a glass or polymer support whereupon a layer or pattern of a transparent conductive oxide (TCO) is provided. Examples of such conductive oxides are ITO (Indium Tin Oxide), ZnO, $SnO_2$ or doped oxides such as ZnO:Al.

A particularly preferred TCO is ITO.

A preferred paper based support is the Powercoat HD® paper substrate, a substrate designed for printed electronics by Arjowiggins Creative Papers.

Multiple metallic layers or patterns, i.e. a stack of patterned or unpatterned layers, may be applied on a substrate. The support referred to in the method of preparing the metallic layers or patterns thus also encompass a previously applied metallic layer or pattern.

Receiving layer

In a preferred embodiment, a receiving layer is applied on the substrate and the silver ink is then applied on the receiving layer.

Such a preferred method comprises the steps of:

- applying a receiving layer on a substrate,
- applying the silver ink described above on at least a part of the receiving layer thereby forming a silver pattern, and
- sintering the silver pattern.

The receiving layer may be applied on the substrate as a coating covering substantially the entire substrate. The silver ink is then applied on at least a part of the receiving layer.

However, the receiving layer may also be imagewise applied on the substrate.

For example, the receiving layer may be applied on the substrate according to a first image. The silver ink is then applied on at least part of that first image.

Preferably, the receiving layer is printed slightly wider than the silver ink to ensure an improved adhesion, resolution and efficient curing.

This can be realized with minimal use of additional ink, because with the high positioning accuracy of inkjet equipment, one could create the necessary pattern for the receiving layer (first image) by a simple "fattening" or "widening" of the silver pattern (for example a silver circuitry). This could be accomplished quite easily in a digital workflow.

The receiving layer is preferably applied to the substrate as a UV curable inkjet ink by inkjet printing.

A UV curable inkjet ink is preferred to obtain a receiving layer with a sufficient roughness Rz and to realize a sufficient adhesion of the receiving layer on various substrates. The Rz obtained may optimized by adjusting the spreading properties of the inkjet ink, or by adusting the UV curing parameters.

Although UV curable inkjet inks are preferred, also thermally curable inks can be employed and similar rough layers can be achieved by adjusting thermal curing parameters.

The roughness Rz of the receiving layer is preferably between 1 to 75 μm, preferably between 2 μm and 60 μm, more preferably between 5 and 50 μm.

The roughness Ra of the receiving layer is preferably between 0.5 and 20 μm, more preferably between 1 and 15 μm, most preferably between 2 and 10 μm.

It has been observed that the insertion of the receiving layer having a roughness between 1 and 75 μm between the substrate and the metallic pattern results in an improved adhesion of the pattern and a better printing resolution of the pattern.

The thickness of the receiving layer is preferably between 10 and 500 μm, more preferably between 20 and 350 μm, most preferably between 30 and 250 μm.

A preferred white receiving layer and a white UV curable inkjet ink to prepare such a white receiving layer is disclosed in EP-A 18171221.7 (filed on 08-05-2018).

## Preparation of the silver ink

The preparation of the silver ink typically comprises the addition of a liquid carrier and the other ingredients to the silver particles by using a homogenization technique such as stirring, high shear mixing, ultra-sonication, or a combination thereof.

The silver particles from which the silver ink is made is typically a paste or a highly concentrated dispersion of silver nanoparticles.

A preferred preparation method of silver nanoparticles is disclosed in EP-A 2671927.

It has been observed that better results may be obtained when all, or a portion, of the dispersion-stabilizing compound are added during the preparation method of the silver nanoparticles. Due to their adsorption to the silver nanoparticles, the dispersion-stabilizing compounds added during the preparation of the silver nanoparticles will be retained, at least partially, in the final silver nanoparticle dispersion, even if one or more washing steps have been carried out in the preparation method.

The homogenization step can be carried out at elevated temperature up to 100°C. In a preferred embodiment, the homogenization step is carried out at temperature equal or below 60°C.

## Inkjet printing devices

Various embodiments of an apparatus for creating the conductive patterns or the receiving layer by inkjet printing may be used.

In a flat bed printing device a support is provided on a flat bed. Droplets of a silver inkjet fluid are jetted from a print head on the support.

The print heads typically scan back and forth in a transversal direction (x-direction) across a moving support (y-direction). Such bi-directional printing is referred to as multi-pass printing.

Another preferred printing method is the so-called single-pass printing method wherein the print heads, or multiple staggered print heads, cover the entire width of the support. In such a single-pass printing method, the print heads usually remain stationary while the support is transported under the print heads (y-direction).

To obtain maximal dot placement accuracy, the print heads are positioned as close as possible to the surface of the support. The distance between the print heads and the surface of the support is preferably less than 3 mm, more preferably less than 2 mm, most preferably less than 1 mm.

As the distance between the print head and the surface of the support may influence the dot placement accuracy, it may be advantageous to measure the thickness of a support and adapting the distance between the print head and

the surface of the support based on the measurement of the thickness of the support.

The distance between a stationary print head and the surface of a support mounted on the printing device may also vary over the whole support, due to for example waviness of the support, or other irregularities in the surface of the support. Therefore it may also be advantageous to measure the surface topography of the support and to compensate the differences in the measured surface topography by controlling the so-called firing time of the droplets of curable fluids on the support, or by adjusting the distance between the print head and the surface of the support. Examples of measurement devices to measure the surface topography of a lithographic supports is disclosed in ISO 12635:2008(E).

In a preferred embodiment the inkjet printing device has holding down means, such as a vacuum chamber under the support, to hold down the support in a so-called hold-down zone, for example by vacuum. In a more preferred embodiment the support is hold down against the support by independent working holding down means such as a plurality of vacuum chambers under the support which are independently controlled to enhance the vacuum pressure on the support so that more than one hold down zones are generated on the support. The holding down of the support enhances the drop placement of the jetted droplets and position accuracy.

Print head

The UV curable inkjet ink and the silver inkjet ink may be jetted by one or more print heads ejecting small droplets of ink in a controlled manner through nozzles onto an ink-receiving layer surface, which is moving relative to the print head(s).

A preferred print head for the inkjet printing system is a piezoelectric head. Piezoelectric inkjet printing is based on the movement of a piezoelectric ceramic transducer when a voltage is applied thereto. The application of a voltage changes the shape of the piezoelectric ceramic transducer in the print head creating a void, which is then filled with ink. When the voltage is again removed, the ceramic expands to its original shape, ejecting a drop of ink from the print head. However the inkjet printing method according to the present invention is not restricted to piezoelectric inkjet printing.

Preferred print heads eject droplets having a volume $\leq$ 50 pL, for example $\leq$ 35 pL or $\leq$ 25 pL. It has been observed that droplets having a bigger volume result in a higher Roughness of the printed receiving layer.

Another preferred print head is a throughflow piezoelectric inkjet print head. A throughflow piezoelectric inkjet print head is a print head wherein a continuous flow of liquid is circulating through the liquid channels of the print head to avoid agglomerations in the liquid which may cause disturbing effects in the flow and bad drop placements. Avoiding bad drop placements by using throughflow piezoelectric inkjet print heads may improve the quality of the conductive patterns on the support. Another advantage of using such throughflow print heads is a higher viscosity limit of the curable fluids to be jetted, widening the scope of compositional variations of the fluids.

The inkjet print head normally scans back and forth in a transversal direction across the moving ink-receiving layer surface. Often the inkjet print head does not print on the way back. Bi-directional printing is preferred for obtaining a high areal throughput. Another preferred printing method is by a "single pass printing process", which can be performed by using page wide inkjet print heads or multiple staggered inkjet print heads which cover the entire width of the ink-receiving layer surface. In a single pass printing process the inkjet print heads usually remain stationary and the substrate surface is transported under the inkjet print heads.

The receiving layer may be applied in a single pass of a multipass printing process. A multipass printing process maybe preferred to achieve a sufficient thickness of the receiving layer.

Applications

With the method according to the present invention using highly conductive metallic layers or patterns may be realized on substrates that do not withstand high temperatures, such as polycarbonate (PC), polyethylene (PE), polypropylene (PP), polymethylacrylate (PMMA), polyvinylidenefluoride (PVDF), polytetrafluorethylene, Nylon-6,6, polyester, polyvinylchloride (PVC), or polystyrene (PS).

Industrial applications that requires high productivity and reliability can benefit from the use of the herein developed Ag inkjet ink. Applications such fabrication of RFID antenna for smart packaging, sensors for point-of-care diagnostics and capacitive touch sensors.

With the method, highly conductive patterns may be provided on a FR-4 substrate, commonly used in the preparation of PCB.

## EXAMPLES

Materials

All materials used in the following examples were readily available from standard sources such as ALDRICH

CHEMICAL Co. (Belgium) and ACROS (Belgium) unless otherwise specified. The water used was deionized water.

Measurements Methods

Conductivity of the silver coatings

The surface resistance (*SER*) of the silver coatings was measured using a four-point collinear probe. The surface or sheet resistance was calculated by the following formula:

$$SER = (\pi/\ln 2)*(V/I)$$

wherein

*SER* is the surface resistance of the layer expressed in Ω/square;
π is a mathematical constant, approximately equal to 3.14;
In2 is a mathematical constant equal to the natural logarithmic of value 2, approximately equal to 0.693;
V is voltage measured by voltmeter of the four-point probe measurement device;
I is the source current measured by the four-point probe measurement device.

For each sample, six measurements were performed at different positions of the coating and the average value was calculated.

The silver content $M_{Ag}$ (g/m$^2$) of the coatings was determined by WD-XRF.

The conductivity of the coated layers was then determined by calculating the conductivity as a percentage of the bulk conductivity of silver using the following formula:

$$\%\mathrm{Ag}_{(\mathrm{bulk})} = \frac{\sigma_{\mathrm{Coat}}}{\sigma_{\mathrm{Ag}}} \times 100$$

$$\%\mathrm{Ag}_{(\mathrm{bulk})} = \frac{\rho_{\mathrm{Ag}}}{\sigma_{\mathrm{Ag}} \times SER \times M_{\mathrm{Ag}}} \times 100$$

wherein $\sigma_{Ag}$ the specific conductivity of silver (equal to 6.3 x 10$^7$ S/m), $\sigma_{Coat}$ is the specific conductivity of the Ag coating and $\rho_{Ag}$ is the density of silver (1.049 x 10$^7$ g/m$^3$).

Viscosity measurements

Unless otherwise provided, viscosities were measured at 25°C at a shear rate of 1000 s$^{-1}$ using a commercially availabe viscosimeter for example as a DHR-2 Rheometer (double wall ring) from TA Instruments.

Example 1

The silver screen ink SI-P2000, commercially available from Agfa Gevaert NV, was screen printed using a P150 screen mesh on different substrates as shown in Table 3

The LexanTM substrates are all polycarbonate substrates commercially available from Tekra.

The Makrofol® substrates are all polycarbonate substrates commercially available from Covestro.

Autostat CT7 is a polyester substrate commercially available from MacDermid.

Sintering of the printed silver was carried out in both a "one-step" or a "two-step" process.

In the "one-step" sintering process, the printed silver is subjected to a treatment at high temperature and relative humidity as shown in Table 3.

In the "two-step" sintering process, as disclosed in WO 2017/139641, the printed silver is in a first step subjected to a heat treatment (referred to as drying/annealing) at low RH’s and then in a second step subjected to a heat treatment at high RH’s.

The conductivities, measured as described above, after sintering are shown in Table 3.

Table 3

| substrate | drying/annealing (85°C; 3 minutes) | sintering (85°C, 85% RV, 24 hours) | SER (Ω/ square) |
|---|---|---|---|
| Lexan True 2 Form | YES | YES | 0.042 |
| Lexan True 2 Form | | YES | 0.037 |
| Lexan 8010 ME | YES | YES | 0.039 |
| Lexan 8010 ME | | YES | 0.037 |
| Lexan 8A73 Polished | YES | YES | 0.056 |
| Lexan 8A73 Polished | | YES | 0.039 |
| Lexan 8A73 Matte | YES | YES | 0.062 |
| Lexan 8A73 Matte | | YES | 0.037 |
| Lexan True2Form Hifi 256 Polished | YES | YES | 0.048 |
| Lexan True2Form Hifi 256 Polished | | YES | 0.036 |
| Lexan True2Form Hifi 256 Matte | YES | YES | 0.067 |
| Lexan True2Form Hifi 256 Matte | | YES | 0.032 |
| Makrofol DE 1-4 Polished | YES | YES | 0.054 |
| Makrofol DE 1-4 Polished | | YES | 0.039 |

It is clear from the results of Table 3 that the conductivity obtained with a one-step sintering method results in a higher conductivity compared to a two-step sintering method.

Moreover, it has been observed that using the two-step sintering method often results in mud cracking of the printed silver pattern, while this is not the case when the one-step sintering method is used.

Example 2

The silver inkjet ink SI-J20X was printed using a Ceraprinter (available from Ceradrop and equipped with Konica Minolta 30 pL printheads KM1024i LHE) on the substrates shown in Table 4.

Mylar A is a polyester substrate commercially available from Dupont.

Powercoat HD is a paper substrate designed for high-definition patterning commercially available from Arjowiggins Creative Papers.

The printed silver ink is subjected to a "one-step" sintering process using the conditions shown in Table 4.

Table 4

| Sintering | | | SER (Ω/square) | |
|---|---|---|---|---|
| Temp (°C) | RH (%) | Time (hours) | Mylar A | Powercoat HD |
| 85 | - | 4 | 1.969 | 38.825 |
| 85 | - | 24 | 0.627 | 30.088 |
| 85 | - | 96 | 0.324 | 4.295 |
| 85 | 85 | 4 | 0.263 | 0.803 |
| 85 | 85 | 24 | 0.236 | 0.463 |
| 85 | 85 | 96 | 0.198 | 0.214 |

(continued)

| Sintering | | | SER (Ω/square) | |
|---|---|---|---|---|
| Temp (°C) | RH (%) | Time (hours) | Mylar A | Powercoat HD |
| 150 | - | 0.5 | 0.123 | - |

It is clear from the results of Table 4 that in a one-step sintering method, good conductivities at low temperatures, for example 85°C, are only obtained at high relative humidities, for example 85%.

## Claims

**1.** A method of preparing a conductive silver pattern on a substrate comprising the steps of:

- applying a silver ink on the substrate to form a silver pattern, and
- sintering the applied silver pattern in one step at a temperature of at least 50°C and a relative humidity (RH) of at least 50 %.

**2.** The method according to claim 1 wherein the temperature is at least 70°C.

**3.** The method according to claim 1 or 2 wherein the relative humidity is at least 80 %.

**4.** The method according to any of the preceding claims wherein sintering is carried out for an amount of time between 1 minute and 200 hours.

**5.** The method according to claim 4 wherein the amount of time is between 30 minutes and 50 hours.

**6.** The method according to any of the preceding claims wherein the silver ink comprises a dispersion stabilizing compound (DSC) having a chemical structure according to Formulae I to IV,

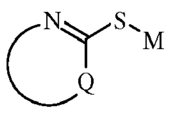

Formula I

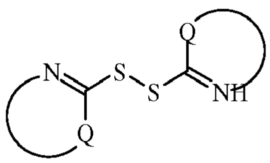

Formula II

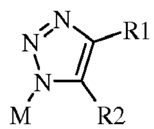

Formula III

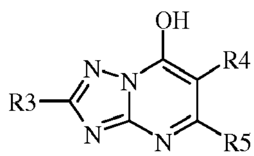

Formula IV

wherein

Q represents the necessary atoms to form a substituted or unsubstituted five or six membered heteroaromatic ring;
M is selected from the group consisting of hydrogen, a monovalent cationic group and an acyl group;
R1 and R2 are independently selected from the group consisting of a hydrogen, a substituted or unsubstituted alkyl group, a substituted or unsubstituted alkenyl group, a substituted or unsubstituted alkynyl group, a substitued or unsubstituted alkaryl group, a substituted or unsubstituted aralkyl group, a substituted or unsubstituted aryl or heteroaryl group, a hydroxyl group, a thioether, an ether, an ester, an amide, an amine, a halogen, a ketone and an aldehyde;
R1 and R2 may represent the necessary atoms to form a five to seven membered ring;
R3 to R5 are independently selected from the group consisting of a hydrogen, a substituted or unsubstituted alkyl group, a substituted or unsubstituted alkenyl group, a substituted or unsubstituted alkynyl group, a substituted or unsubstituted alkaryl group, a substituted or unsubstituted aralkyl group, a substituted or unsubstituted aryl or heteroaryl group, a hydroxyl group, a thiol, a thioether, a sulfone, a sulfoxide, an ether, an ester, an amide, an amine, a halogen, a ketone, an aldehyde, a nitrile and a nitro group;
R4 and R5 may represent the necessary atoms to form a five to seven membered ring.

7. The method according to any of the preceding claims wherein the silver ink comprises a Dispersion Stabilizing Compound (DSC) according to Formula I,

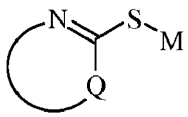

Formula I

wherein

M is selected from the group consisting of hydrogen, a monovalent cationic group and an acyl group; and
Q represents the necessary atoms to form a five membered heteroaromatic ring.

8. The method according to claim 7 wherein M in Formula I is a hydrogen.

9. The method according to claim 7 or 8 wherein Q is a five membered heteroaromatic ring selected from the group consisting of an imidazole; a benzimidazole; a thiazole; a benzothiazole; an oxazole; a benzoxazole; a 1,2,3-triazole; a 1,2,4-triazole; an oxadiazole; a thiadiazole and a tetrazole.

10. The method according to any of the claims 6 to 9 wherein the dispersion-stabilizing compound is selected from the group consisting of N,N-dibutyl-(2,5-dihydro-5-thioxo-1H-tetrazol-1-yl-acetamide, 5-heptyl-2-mercapto-1,3,4-oxadiazole, 1-phenyl-5-mercaptotetrazol, 5-methyl-1,2,4-triazolo-(1,5-a) primidine-7-ol, and S-[5-[(ethoxycarbonyl)amino]-1,3,4-thiadiazol-2-yl] O-ethyl thiocarbonate.

11. The method according to any of the claims 6 to 10 wherein the amount of the Dispersion Stabilizing Compound (DSC) is less than 5 wt% relative to the weight of the silver in the ink.

12. The method according to any of the preceding claims wherein the silver ink is a silver inkjet ink or a silver screen ink.

13. The method according to any of the preceding claims wherein a receiving layer is applied on the substrate before applying the silver ink.

14. The method according to any of the preceding claims wherein the silver ink comprises a liquid carrier selected from the group consisting of 2-phenoxy ethanol, propylene carbonate, propylene glycol, n-butanol and 2-pyrrolidone.

15. The method according to any of the preceding claims wherein the substrate is a polycarbonate, polyvinylchloride, polystyrene or polyester based substrate.

Europäisches Patentamt
European Patent Office
Office européen des brevets

# EUROPEAN SEARCH REPORT

Application Number
EP 19 17 1772

## DOCUMENTS CONSIDERED TO BE RELEVANT

| Category | Citation of document with indication, where appropriate, of relevant passages | Relevant to claim | CLASSIFICATION OF THE APPLICATION (IPC) |
|---|---|---|---|
| X,D | EP 3 037 161 A1 (AGFA GEVAERT [BE]) 29 June 2016 (2016-06-29)<br>* the whole document *<br>* paragraph [0176] - paragraph [0234]; claim 15; examples *<br>* paragraph [0150] - paragraph [0154] *<br>----- | 1-15 | INV.<br>C09D11/52<br>C09D11/38<br>C09D11/037<br>H05K3/12 |
| X | WO 2017/211853 A1 (AGFA-GEVAERT N V [BE]) 14 December 2017 (2017-12-14)<br>* the whole document *<br>* paragraph [0115]; claims 12,13; examples *<br>* paragraph [0136] - paragraph [0144] *<br>----- | 1-15 | |
| X | WO 2013/115300 A1 (UNIV YAMAGATA [JP]) 8 August 2013 (2013-08-08)<br>* the whole document *<br>* paragraph [0068]; examples 12, 14; table 1 *<br>* paragraph [0070] - paragraph [0072] *<br>----- | 1-15 | TECHNICAL FIELDS SEARCHED (IPC) |
| X,D | WO 2017/139641 A1 (TE CONNECTIVITY CORP [US]) 17 August 2017 (2017-08-17)<br>* the whole document *<br>* paragraph [0045] - paragraph [0049]; figure 3; table 1 *<br>----- | 1-15 | C09D<br>H05K |

The present search report has been drawn up for all claims

1

| Place of search | Date of completion of the search | Examiner |
|---|---|---|
| Munich | 19 September 2019 | Rangheard, Claudine |

CATEGORY OF CITED DOCUMENTS

X : particularly relevant if taken alone
Y : particularly relevant if combined with another document of the same category
A : technological background
O : non-written disclosure
P : intermediate document

T : theory or principle underlying the invention
E : earlier patent document, but published on, or after the filing date
D : document cited in the application
L : document cited for other reasons

& : member of the same patent family, corresponding document

EPO FORM 1503 03.82 (P04C01)

## ANNEX TO THE EUROPEAN SEARCH REPORT ON EUROPEAN PATENT APPLICATION NO. EP 19 17 1772

This annex lists the patent family members relating to the patent documents cited in the above-mentioned European search report. The members are as contained in the European Patent Office EDP file on
The European Patent Office is in no way liable for these particulars which are merely given for the purpose of information.

19-09-2019

| Patent document cited in search report | Publication date | Patent family member(s) | Publication date |
|---|---|---|---|
| EP 3037161 A1 | 29-06-2016 | CN 107107185 A | 29-08-2017 |
| | | EP 3037161 A1 | 29-06-2016 |
| | | JP 2018508925 A | 29-03-2018 |
| | | KR 20170084157 A | 19-07-2017 |
| | | TW 201640521 A | 16-11-2016 |
| | | US 2017349773 A1 | 07-12-2017 |
| | | WO 2016102192 A1 | 30-06-2016 |
| WO 2017211853 A1 | 14-12-2017 | CN 109312181 A | 05-02-2019 |
| | | EP 3469030 A1 | 17-04-2019 |
| | | JP 2019524908 A | 05-09-2019 |
| | | KR 20190008281 A | 23-01-2019 |
| | | US 2019144698 A1 | 16-05-2019 |
| | | WO 2017211853 A1 | 14-12-2017 |
| WO 2013115300 A1 | 08-08-2013 | JP 2013161593 A | 19-08-2013 |
| | | WO 2013115300 A1 | 08-08-2013 |
| WO 2017139641 A1 | 17-08-2017 | US 2017238425 A1 | 17-08-2017 |
| | | WO 2017139641 A1 | 17-08-2017 |

EPO FORM P0459

For more details about this annex : see Official Journal of the European Patent Office, No. 12/82

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description

- EP 2671927 A
- EP 3037161 A
- WO 2017139641 A
- EP 2468827 A
- EP 2821164 A
- EP 3016763 A
- US 3649336 A
- GB 1441591 A
- WO 2015000932 A
- EP 18171221 A